# EUROPEAN PATENT APPLICATION

(11) **EP 4 693 416 A1**
(43) Date of publication of application: **11.02.2026**
(21) Application number: 23938197.3
(22) Date of filing: 24.10.2023
(51) Int. Cl.: H01L 31/05, H01L 31/048

(54) **BUSBAR AND PHOTOVOLTAIC MODULE**

(30) Priority: 19.05.2023 CN 202321220493 U
(71) Applicant: Ja Solar Technology Yangzhou Co., Ltd., Yangzhou, Jiangsu 225131 (CN)
(72) Inventor: LI, Lingxian, Yangzhou, Jiangsu 225131 (CN); CHEN, Bin, Yangzhou, Jiangsu 225131 (CN); HUANG, Zongming, Yangzhou, Jiangsu 225131 (CN)
(74) Representative: Sun, Yiming
(86) International application number: PCT/CN2023/126093
(87) International publication number: WO 2024/239529

(57) **Abstract**

The present disclosure relates to a busbar and a photovoltaic module, the busbar comprising a conductive metal substrate, wherein the surface of the conductive metal substrate is covered with an insulating layer, and the insulating layer is provided, on one side of the conductive metal substrate, with a plurality of non-insulating opening regions in which a solder layer is filled, the solder layer being in contact with the conductive metal substrate. The busbar in the present disclosure is integrated as a whole, in which an insulating layer covers the surface of the conductive metal substrate and a solder layer is filled in the non-insulating opening regions on the insulating layer. Therefore, during the laying of the busbar in the present disclosure, the busbar is directly laid as a whole, and the insulating layer and the conductive metal substrate are not laid separately, which simplifies the manufacturing process and improves the laying efficiency in the manufacturing process.

## Description

### CROSS REFERENCES TO RELATED APPLICATIONS

This application claims the priority of the Chinese patent application No. 202321220493.0 filed on May 19, 2023, the disclosure of which is hereby incorporated by reference in its entirety.

### TECHNICAL FIELD

The present disclosure relates to the technical field of solar cells, in particular to a busbar and a photovoltaic module.

### BACKGROUND

A photovoltaic module, as a core unit for solar power generation, comprises a back plate material, a rear adhesive film, a battery string array, a front adhesive film and a cover plate material, wherein battery strings are connected via busbars and interconnecting welding strips, busbars are generally located at both ends of battery strings, and interconnecting welding strips are located at both ends of battery strings and welded to busbars. Busbars are generally tinned copper flat strips with a larger cross-sectional area, and they need to carry a current much larger than that of the interconnecting welding strips. Accordingly, busbars have a much larger cross-sectional area, which not only affects the aesthetic appearance and the module efficiency, but also causes a certain amount of waste in the solar cell module materials. Therefore, how to effectively reduce the area occupancy rate of the photovoltaic module by the busbars is important research content for improving solar cell modules.

In the technical field of solar cells, the pursuit of a lower production cost and a higher photoelectric conversion efficiency is a core objective of the solar cell industry, wherein a back contact solar cell is different from a conventional solar cell, and both positive and negative electrodes of a back contact solar cell are placed on the back side of the cell, thereby avoiding optical losses similar to those on the front side of a conventional solar cell and improving the photoelectric conversion efficiency of the cell. Therefore, the back contact cell is one type of cells that has been widely concerned and studied in the technical field of high efficiency cells.

In the back contact cell technology, busbars are disposed on the back side of cells in order to reduce an ineffective area occupied by the busbars in a photovoltaic module. A current manner of laying a busbar on the back side of cells is laying an insulating layer and a conductive metal substrate separately, and the manufacturing process is relatively complicated, which therefore results in relatively low busbar manufacturing efficiency.

### SUMMARY

In order to solve the above technical problem, the present disclosure provides a busbar and a photovoltaic module, which can improve the laying efficiency in the manufacturing process.

On the one hand, the present disclosure provides a busbar comprising a conductive metal substrate, wherein the surface of the conductive metal substrate is covered with an insulating layer, and the insulating layer is provided, on one side of the conductive metal substrate, with a plurality of non-insulating opening regions in which a solder layer is filled, the solder layer being in contact with the conductive metal substrate.

In one embodiment of the present disclosure, the conductive metal substrate is one of metal copper, copper alloy, silver, silver alloy, gold and gold alloy.

In one embodiment of the present disclosure, the solder layer is one of tin, tin-bismuth alloy, tin-lead alloy, and tin-bismuth-lead alloy.

In one embodiment of the present disclosure, the insulating layer is one or more of aluminum oxide, calcium oxide, iron oxide, barium oxide, magnesium oxide, titanium oxide, chromium oxide, iron sulfide, zirconium oxide, silicon oxide, silicon carbide, and polyimide.

In one embodiment of the present disclosure, the insulating layer is provided with a buffer layer on one side opposite to the non-insulating opening regions.

In one embodiment of the present disclosure, the buffer layer is one or more of an EVA film, a POE film, and a PVB film.

In one embodiment of the present disclosure, the width of the buffer layer is less than or equal to the width of the insulating layer, and the length of the buffer layer is less than or equal to the length of the insulating layer.

In one embodiment of the present disclosure, the width of the buffer layer is equal to the width of the insulating layer, and the length of the buffer layer is equal to the length of the insulating layer.

On the other hand, there is provided a photovoltaic module comprising a battery string array, the battery string array including a plurality of battery strings, wherein two adjacent battery strings are connected via a busbar and welding strips.

In one embodiment of the present disclosure, the photovoltaic module further comprises a back plate, a rear adhesive film, a front adhesive film and a cover plate.

The above technical solution of the present disclosure has the following advantages over the existing art:
The busbar according to the present disclosure is integrated as a whole, in which an insulating layer covers the surface of the conductive metal substrate and a solder layer is filled in the non-insulating opening regions on the insulating layer. Therefore, during the laying of the busbar in the present disclosure, the busbar is directly laid as a whole, and the insulating layer and the conductive metal substrate are not laid separately, which simplifies the manufacturing process and improves the laying efficiency in the manufacturing process.

### BRIEF DESCRIPTION OF THE DRAWINGS

In order to more clearly illustrate the technical solution in the embodiments of the present disclosure, the drawings required for use in the description of the embodiments will be introduced briefly as below. Obviously, the drawings described below are only used in some embodiments of the present disclosure. For those of ordinary skills in the art, other drawings can be further obtained according to these drawings without paying any inventive efforts.
FIG. 1 is a structural diagram of a battery string array of a photovoltaic module in the present disclosure;
FIG. 2 is a first structural diagram of busbar-connected battery strings of a photovoltaic module in the present disclosure;
FIG. 3 is a second structural diagram of busbar-connected battery strings of the photovoltaic module in the present disclosure;
FIG. 4 is a schematic diagram of a top view of a busbar in the present disclosure;
FIG. 5 is a first cross-sectional schematic view of a busbar in the present disclosure;
FIG. 6 is a second cross-sectional schematic view of a busbar in the present disclosure;
FIG. 7 is a cross-sectional schematic view of busbar-connected battery strings of a photovoltaic module in the present disclosure;
FIG. 8 is a partial enlarged schematic diagram of the busbar in FIG. 7;
FIG. 9 is a schematic cross-sectional view of a busbar in the existing art;
FIG. 10 is a structural diagram of busbar-connected battery strings of a photovoltaic module in the existing art;
FIG. 11 is a structural diagram of busbar-connected battery strings of a photovoltaic module in the existing art;
FIG. 12 is a partial enlarged schematic diagram of a photovoltaic module in the existing art when the insulating layer is shortened at the busbar.

### REFERENCE SIGNS IN THE DRAWINGS OF THE DESCRIPTION

10. busbar; 11. conductive metal substrate; 12. insulating layer; 13. solder layer; 14. buffer layer; 15. battery string; 16. non-insulating opening region; 17. battery string array; 20. welding strip; 30. cell; 31. electrode.

### DETAILED DESCRIPTION

The technical solutions in the embodiments of the present disclosure will be clearly and completely described below with reference to the drawings in the embodiments of the present disclosure. Obviously, the embodiments as described are only part, not all, of the embodiments in the present disclosure. Based on the embodiments in the present disclosure, all other embodiments obtained by those of ordinary skills in the art without paying any inventive efforts shall fall within the protection scope of the present disclosure.

### Embodiment 1

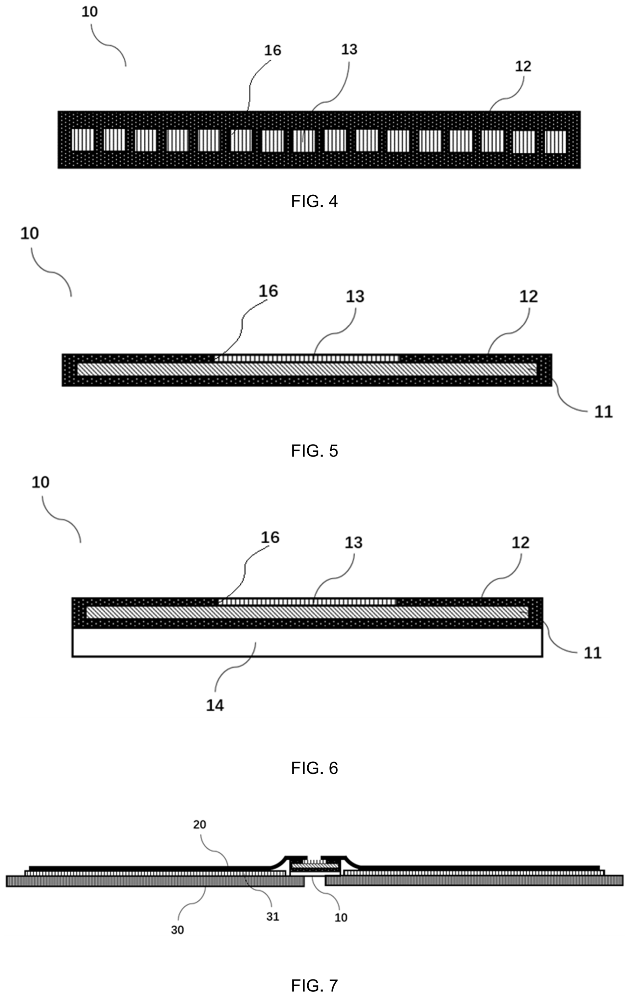

As shown in FIG. 5, the busbar 10 of the present disclosure comprises a conductive metal substrate 11, wherein the surface of the conductive metal substrate 11 is covered with an insulating layer 12, and the insulating layer 12 is provided, on one side of the conductive metal substrate 11, with a plurality of non-insulating opening regions 16 in which a solder layer 13 is filled, the solder layer 13 being in contact with the conductive metal substrate 11.

The busbar 10 as shown in FIG. 5 comprises a conductive metal substrate 11, an insulating layer 12 and a solder layer 13. The insulating layer 12 covers the surface of the conductive metal substrate 11 which has two surfaces, wherein the insulating layer 12 corresponding to one of the surfaces is provided with a plurality of non-insulating opening regions 16 which are rectangular and are arranged in a linear array on the insulating layer 12, as shown in FIG. 4. The non-insulating opening regions 16 are used for filling a solder layer 13, and the solder layer 13 is in contact with the conductive metal substrate 11 to achieve an electrical connection.

The busbar 10 in the present disclosure is integrated as a whole, in which the insulating layer 12 covers the surface of the conductive metal substrate 11, and the solder layer 13 is filled in the non-insulating opening regions 16 on the insulating layer 12. Therefore, during the laying of the busbar 10 in the present disclosure, the busbar 10 is directly laid as a whole, and the insulating layer 12 and the conductive metal substrate 11 are not laid separately, which simplifies the manufacturing process and improves the laying efficiency in the manufacturing process. The conductive metal substrate 11 is one of metal copper, copper alloy, silver, silver alloy, gold and gold alloy; the solder layer 13 is tin or tin alloy, the tin alloy being one of tin-bismuth alloy, tin-lead alloy, and tin-bismuth-lead alloy, which have good conductivity; the insulating layer 12 is one or more of aluminum oxide, calcium oxide, iron oxide, barium oxide, magnesium oxide, titanium oxide, chromium oxide, iron sulfide, zirconium oxide, silicon oxide, silicon carbide, and polyimide, which have good insulating ability. In addition, the busbar 10 of the present disclosure is applied in the field of back contact cells, and both the positive and negative electrodes 31 are placed on the back side of the cell 30, which effectively reduces the ineffective area of the photovoltaic module and improves the photoelectric conversion efficiency of the cell.

### Embodiment 2

As shown in FIG. 6, the busbar 10 of the present disclosure comprises a conductive metal substrate 11, wherein the surface of the conductive metal substrate 11 is covered with an insulating layer 12, the insulating layer 12 is provided, on one side of the conductive metal substrate 11, with a plurality of non-insulating opening regions 16 in which a solder layer 13 is filled, the solder layer 13 being in contact with the conductive metal substrate 11, and the insulating layer 12 is provided with a buffer layer 14 on one side opposite to the non-insulating opening regions 16.

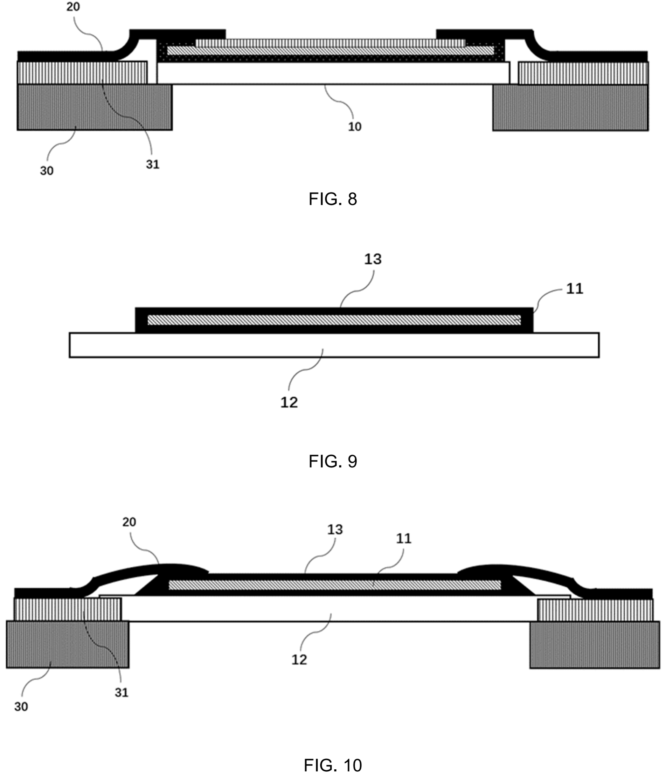

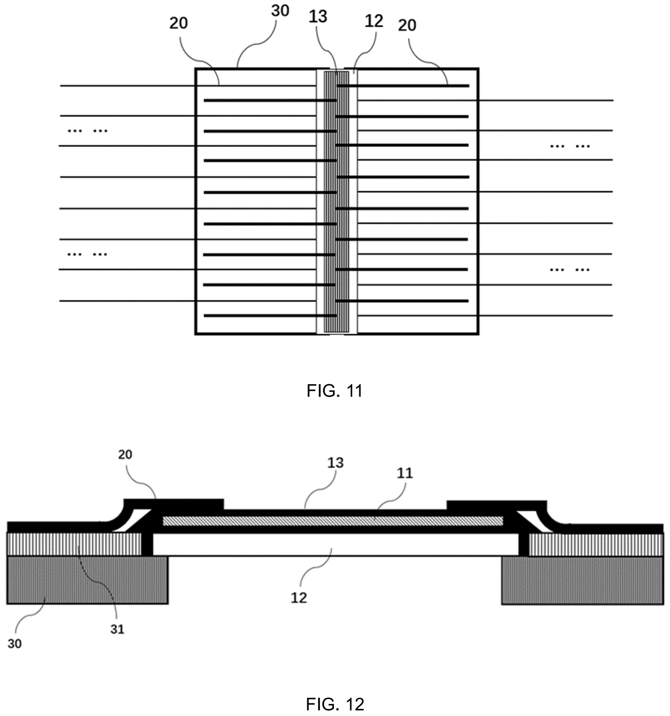

The busbar 10 as shown in FIG. 6 comprises a conductive metal substrate 11, an insulating layer 12, a solder layer 13 and a buffer layer 14. The insulating layer 12 covers the surface of the conductive metal substrate 11 which has two surfaces, wherein the insulating layer 12 on one of the surfaces is provided with a plurality of non-insulating opening regions 16 which are rectangular and are arranged in a linear array on the insulating layer 12. The non-insulating opening regions 16 are used for filling a solder layer 13, and the solder layer 13 is in contact with the conductive metal substrate 11 to achieve an electrical connection. The insulating layer 12 on the other surface of the conductive metal substrate 11 is provided at the bottom with a buffer layer 14, i.e., the insulating layer 12 is provided with a buffer layer 14 on one side opposite to the non-insulated opening regions 16. As shown in FIG. 9 and FIG. 10, the busbar 10 of the existing art is not provided with a buffer layer 14, which indicates that the insulating layer 12 is directly placed on the cell 30. In a lamination procedure in the subsequent manufacturing process, since there is only an insulating layer 12 between the conductive metal substrate 11 and the cell 30, a phenomenon that the conductive metal substrate 11 fractures the cell 30 would occur during the lamination procedure. However, in the present disclosure, the busbar 10 is provided with a buffer layer 14 which is one or more of an EVA film, a POE film, and a PVB film, and the buffer layer 14 is relatively soft and can play a buffering role on the cell 30 during the lamination procedure, similar to the effect of a sponge, thereby effectively reducing the probability of the cell 30 being fractured. Furthermore, the width of the buffer layer 14 is less than or equal to the width of the insulating layer 12, and the length of the buffer layer 14 is less than or equal to the length of the insulating layer 12, preferably, the width of the buffer layer 14 is equal to the width of the insulating layer 12, and the length of the buffer layer 14 is equal to the length of the insulating layer 12. In addition, the insulating layer 12 in the busbar 10 of the present disclosure is made of a black or white material, and the material in the buffer layer 14 will become transparent after being laminated. The black or white insulating layer 12 can effectively match traditional black components and white components, making it beautiful in appearance. In addition, the existing art as shown in FIG. 9 and FIG. 10 requires the insulating layer 12 and the conductive metal base 11 to be laid separately, which has low laying efficiency. Moreover, the existing art requires the width of the insulating layer 12 to be greater than the width of the conductive metal base 11 by a certain distance, such that a distance between the welding strip 20 and the solder layer 13 on the busbar 10 is relatively far, which results in a smaller welding area at the welding point after the welding strip 20 is welded to the solder layer 13, thereby leading to poor strain resistance at the welding point and a risk of desoldering and cold soldering at the outermost welding point of the cell 30 at the end of the back contact battery string 15. If the width of the insulating layer 12 is directly reduced on the basis of the existing art, the structure of the busbar 10 of the existing art is prone to a short circuit due to overflow of solder from the busbar 10 during the welding process, as shown in FIG. 11 and FIG. 12. However, as for the busbar 10 in the present disclosure, the probability of a short circuit caused by overflow of solder is reduced because the insulating layer 12 covers the conductive metal substrate 11. Therefore, the present disclosure can reduce the width of the buffer layer 14 under the precondition that the conductive metal substrate 11 is covered with the insulating layer 12, so as to reduce a spacing between the two battery strings 15, and a distance between the welding strip 20 and the solder layer 13 on the busbar 10 can be effectively reduced to increase a welding area at the welding point and further improve the strain resistance at the welding point, thereby reducing the risk of desoldering and cold welding at the welding point.

### Embodiment 3

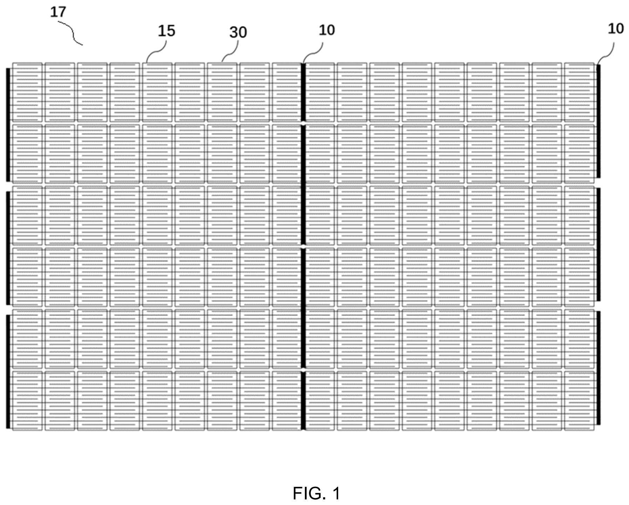

Referring to FIGs. 1 to 3, the photovoltaic module of the present disclosure comprises a battery string array 17, the battery string array 17 including a plurality of battery strings 15, wherein two adjacent battery strings 15 are connected via the busbar 10 and the welding strip 20.

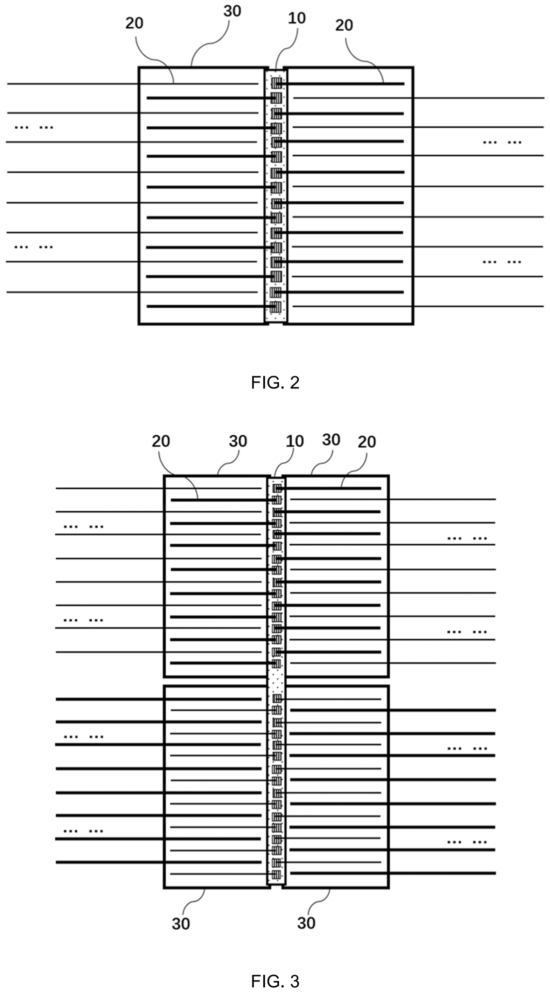

In the photovoltaic module as shown in FIG. 1, the battery string array 17 comprises twelve battery strings 15 (back contact battery strings 15 are used); the battery string array 17 comprises four busbars 10 in the middle, which are referred to as middle busbars 10 for connecting two adjacent battery strings 15 in the same row; and the battery string array 17 comprises six busbars 10 at both ends, three bus bars 10 at each end, which are referred to as end busbars 10 for connecting two adjacent battery strings 15 in the same column, wherein each battery string 15 includes nine cells 30. Further, as for the busbars 10 in the middle of the battery string array 17, the busbars 10 for the first and sixth rows are shown in FIG. 2 and are used for connecting two adjacent battery strings 15 in the same row, which indicates that the electrodes 31 of the same polarity of the two cells 30 close to the middle busbar 10 are electrically connected, and the busbars 10 for the second, third, fourth and fifth rows are shown in FIG. 3, wherein the upper half of the busbar 10 shown in FIG. 3 electrically connects the electrodes 31 of the same polarity on the cells 30 of the two adjacent battery strings 15 in the same row, and the lower half of the busbar 10 electrically connects the electrodes 31 of the same polarity on the cells 30 of the two adjacent battery strings 15 in the same row, the polarity of the electrodes 31 in the upper half being opposite to that of the electrodes 31 in the lower part which are connected to the busbar 10 via welding strips 20, which indicates that the positive electrodes of the battery strings 15 in the upper half are connected to the negative electrodes of the battery strings 15 in the lower half (or the negative electrodes of the battery strings 15 in the upper half are connected to to the positive electrodes of the battery strings 15 in the lower half) to realize a series connection of two adjacent battery strings 15 in the same column.

The busbar 10 and the welding strip 20 connect adjacent battery strings 15, and the connection diagrams are shown in FIG. 7 and FIG. 8. The busbar 10 is located between two adjacent battery strings 15. The cell 30 close to the busbar 10 is provided with an electrode 31, and the electrode 31 is provided with a welding strip 20. The welding strip 20 is welded to the solder layer 13 on the busbar 10 to achieve an electrical connection between the battery strings 15. In addition to the battery string array 17, the busbar 10 and the welding strip 20, the photovoltaic module also comprises a back plate, a rear adhesive film, a front adhesive film and a cover plate to form a complete photovoltaic module. The photovoltaic module using the above busbar 10 simplifies the process of separately laying the insulating layer 12 and the conductive metal substrate 11 in the existing art into a process of directly laying one busbar 10, which effectively improves production efficiency.

Note: The above are only preferred embodiments of the present disclosure and the technical principles used therein. Those skilled in the art will appreciate that the present disclosure is not limited to the specific embodiments described herein and that various obvious changes, rearrangements, and substitutions can be made by those skilled in the art without departing from the protection scope of the present disclosure.

Therefore, although the present disclosure has been described in details through the above embodiments, it is not limited to the above embodiments, and it may also include more other equivalent embodiments without departing from the concept of the present disclosure. However, the scope of the present disclosure is determined by the scope of the pending claims.

## Claims

1. A busbar comprising a conductive metal substrate (11), wherein the surface of the conductive metal substrate (11) is covered with an insulating layer (12), and the insulating layer (12) is provided, on one side of the conductive metal substrate (11), with a plurality of non-insulating opening regions (16) in which a solder layer (13) is filled, the solder layer (13) being in contact with the conductive metal substrate (11).

2. The busbar according to claim 1, wherein the conductive metal substrate (11) is one of metal copper, copper alloy, silver, silver alloy, gold and gold alloy.

3. The busbar according to claim 1, wherein the solder layer (13) is one of tin, tin-bismuth alloy, tin-lead alloy, and tin-bismuth-lead alloy.

4. The busbar according to claim 1, wherein the insulating layer (12) is one or more of aluminum oxide, calcium oxide, iron oxide, barium oxide, magnesium oxide, titanium oxide, chromium oxide, iron sulfide, zirconium oxide, silicon oxide, silicon carbide, and polyimide.

5. The busbar according to claim 1, wherein the insulating layer (12) is provided with a buffer layer (14) on a side opposite to the non-insulating opening regions (16).

6. The busbar according to claim 5, wherein the buffer layer (14) is one or more of an EVA film, a POE film, and a PVB film.

7. The busbar according to claim 5, wherein the width of the buffer layer (14) is less than or equal to the width of the insulating layer (12), and the length of the buffer layer (14) is less than or equal to the length of the insulating layer (12).

8. The busbar according to claim 7, wherein the width of the buffer layer (14) is equal to the width of the insulating layer (12), and the length of the buffer layer (14) is equal to the length of the insulating layer (12).

9. A photovoltaic module using the busbar according to any of claims 1 to 8, wherein the photovoltaic module comprises a battery string array (17) which includes a plurality of battery strings (15), with two adjacent battery strings (15) being connected via the busbar (10) and welding strips (20).

10. The photovoltaic module according to claim 9, wherein the photovoltaic module further comprises a back plate, a rear adhesive film, a front adhesive film and a cover plate.
